# EUROPEAN PATENT APPLICATION

(11) **EP 2 530 723 A2**
(43) Date of publication of application: **05.12.2012**
(21) Application number: 12163317.6
(22) Date of filing: 05.04.2012
(51) Int. Cl.: H01L 31/0328, H01L 31/0352, H01L 31/042, H01L 31/109

(54) **Photovoltaic device comprising silicon microparticles**

(30) Priority: 03.06.2011 EP 11004549
(71) Applicant: Sony Corporation, Tokyo 108-0075 (JP)
(72) Inventor: Ford, William, 70327 Stuttgart (DE); von Wrochem, Florian, 70327 Stuttgart (DE); Nelles, Gabriele, 70327 Stuttgart (DE)
(74) Representative: Appelt, Christian W.

(57) **Abstract**

The present invention relates to a heterojunction photovoltaic device comprising silicon microparticles and to a method of producing the same. The photovoltaic device comprises a conductor layer with a workfunction which matches the Fermi Energy of the silicon microparticle; a semiconductor layer (e.g. CuI, CuSCN, Cu2O); an insulator layer (e.g. an organic film) sandwiched between said conductor layer and said semiconductor layer, and a silicon microparticle, wherein said silicon microparticle is partially embedded in said conductor layer and partially embedded in said insulator layer, and wherein said silicon microparticle is in contact with said semiconductor layer and said conductor layer, and wherein said semiconductor layer comprises a material which is not silicon.

## Description

The present invention relates to a photovoltaic device comprising silicon microparticles and to a method of producing the same.

Photovoltaic cells based on single-crystal silicon offer several advantages for solar energy conversion: they are technically well understood and environmentally stable, and silicon is an abundant and non-toxic element. However, such cells are relatively expensive to manufacture mainly due to the cost of single-crystal, electronic-grade semiconductor silicon. Solar cells based on polycrystalline silicon are less expensive, but they are also less efficient. Amorphous silicon is even less expensive than polycrystalline silicon, but solar cells based on amorphous silicon are even less efficient and are also less environmentally stable. Thus, there is a trade-off between efficiency and cost in conventional photovoltaic cells based on silicon: less expensive forms of silicon yield less efficient devices and therefore larger areas are required to provide the same amount of electric power. Photovoltaic cells based on other kinds of semiconductors are known that can compete with silicon-based cells with respect to cost and/or efficiency, but these generally contain toxic elements such as cadmium or selenium, which could present serious enviromental health hazards in the event of accidents, such as fire. Most commercially available solar cells based on silicon are configured as large-area p-n junctions. The metal-insulator-semiconductor (MIS) junction, wherein a thin (generally less than 3-nm) insulator layer is sandwiched between a metal and silicon, is another type of junction that provides efficient solar cells using silicon as semiconductor. MIS-type solar cells have an inherent cost advantage compared to p-n junction solar cells. A variant of the MIS-type cell in which the insulator layer is bonded via Si-O-C bonds to oxide-free n-Si surfaces, using self-assembly, was reported recently [R. Har-Lavan, I. Ron, F. Thieblemont, D. Cahen (2009) Appl. Phys. Lett., 94, 043308].

It was an object of the present invention to provide for an inexpensive silicon-based photovoltaic device with high efficiency as well as for a method of producing the same.

The objects of the present invention are solved by a photovoltaic device comprising
- a conductor layer (15);
- a semiconductor layer (19);
- an insulator layer (17) sandwiched between said conductor layer (15) and said semiconductor layer (19); and
- a silicon microparticle (13),
wherein said silicon microparticle (13) is partially embedded in said conductor layer (15) and partially embedded in said insulator layer (17),
wherein said silicon microparticle (13) is in contact with said semiconductor layer (19) and said conductor layer (15), and
wherein said semiconductor layer (19) comprises a material which is not silicon.

In one embodiment, there is an interface between said silicon microparticle (13) and said semiconductor layer (19) which interface is a heterojunction.

In one embodiment, said conductor layer (15) comprises a metal or metal alloy which is selected from the group comprising magnesium, hafnium, manganese, indium, gallium, bismuth, silver, aluminium, vanadium, zinc, titanium, tin, brass, bronze, germanium, gold, palladium, and nickel. Alternatively, said conductor layer (15) comprises a carbon-based material which is selected from amorphous carbon, glassy carbon, graphite, graphene, or a conjugated organic polymer such as polythiophene, polypyrrole, or polyaniline. In one embodiment, the work function (WF) of said metal, metal alloy or carbon-based material differs by 0.5 eV or less from the Fermi energy (E_{F}) of the silicon microparticle (13).

In one embodiment, said semiconductor layer (19) comprises a p-type semiconductor or an n-type semiconductor.

In one embodiment, said silicon microparticle (13) comprises n-type silicon or p-type silicon.

In one embodiment, said semiconductor layer (19) comprises a p-type semiconductor and said silicon microparticle (13) comprises n-type silicon. In one embodiment, the valence band energy of the p-type semiconductor and the valence band energy of the n-type silicon microparticle differ by 0.5 eV or less, preferably by 0.3 eV or less.

In one embodiment, said semiconductor layer (19) comprises an n-type semiconductor and said silicon microparticle (13) comprises p-type silicon. In one embodiment, the conduction band energy of the n-type semiconductor and the conduction band energy of the n-type silicon microparticle differ by 0.5 eV or less, preferably by 0.3 eV or less.

In one embodiment, said silicon microparticle (13) has a median volume-based size of 5-500 µm, preferably 5-250 µm, more preferably 5-100 µm, most preferably 10-100 µm.

In one embodiment, the photovoltaic device further comprises an encapsulating layer (25) on said semiconductor layer (19) opposite of said insulator layer (17).

In one embodiment, the photovoltaic device further comprises an adhesive layer (29) on said conductor layer (15) opposite of said insulator layer (17).

In one embodiment, said silicon microparticle (13) is a planarized silicon microparticle (13').

In one embodiment, said planarized silicon microparticle (13') is co-planar with the interface between said semiconductor layer (19) and said insulator layer (17).

In one embodiment, said silicon microparticle (13) further comprises a porous silicon layer (37), wherein said porous silicon layer (37) covers the surface of said silicon microparticle (13) being in contact with said semiconductor layer (19).

In one embodiment, said silicon microparticle (13) is partially embedded in said semiconductor layer (19).

In one embodiment, the photovoltaic device further comprises a barrier layer (35) between said silicon microparticle (13) and said semiconductor layer (19).

In one embodiment, the photovoltaic device further comprises a barrier layer (33) between said silicon microparticle (13) and said conductor layer (15).

In one embodiment, said insulator layer (17) or said semiconductor layer (19) comprises a luminescent dopant (39, 43).

In one embodiment, said encapsulating layer (25) comprises a luminescent dopant (41).

The objects of the invention are solved by a method of producing a photovoltaic device according to the present invention, said method comprising the step of:
- partially embedding silicon microparticles in a conductor layer.

In one embodiment, the method comprises one of the following sequences of steps:
either a):
   - providing a conductor layer (15),
   - depositing an insulator layer (17) on said conductor layer (15),
   - providing silicon microparticles (13),
   - pressing said silicon microparticles through said insulator layer (17) and partially into said conductor layer (15),
   - depositing a semiconductor layer (19) onto said insulator layer (17);
or b):
   - providing, in any order, a conductor layer (15) and silicon microparticles (13),
   - depositing said silicon microparticles (13) on said conductor layer (15),
   - pressing said silicon microparticles (13) partially into said conductor layer (15),
   - depositing an insulator layer (17) onto said conductor layer (15) such that said insulator layer (17) covers said conductor layer (15) and such that said silicon microparticles (13) pressed and partially embedded in said conductor layer (15) become also partially embedded in said insulator layer (17),
   - depositing a semiconductor layer on said insulator layer;
or c):
   - providing, in any order, silicon microparticles (13) and a temporary layer (49),
   - depositing said silicon microparticles (13) onto said temporary layer (49),
   - pressing said silicon microparticles (13) partially into said temporary layer (49), such that said silicon microparticles become partially embedded into said temporary layer,
   - depositing a conductor layer (15) onto said silicon microparticles (13), partially embedded in said temporary layer (49),
   - removing said temporary layer (49),
   - depositing an insulator layer (17) onto said conductor layer (15) such that said insulator layer (17) covers said conductor layer (15) and such that said silicon microparticles partially embedded in said conductor layer become also partially embedded in said insulator layer (17),
   - depositing a semiconductor layer (19) on said insulator layer;
and, wherein said method optionally further comprises the sequence of steps:
   - providing, in any order, an electrical contact to said conductor layer (15) and said semiconductor layer (19) and depositing an encapsulating layer (25) on said semiconductor layer (19),
wherein said conductor layer, insulator layer, silicon microparticles, and semiconductor layer are as defined above.

The present inventors have surprisingly found that by using silicon microparticles which are partially embedded in a conductor layer and partially embedded in an insulator layer sandwiched between the conductor layer and a semiconductor layer, it is possible to provide for an inexpensive silicon-based photovoltaic device with high efficiency. The semiconductor layer comprises a material which is not silicon or silicon-based. In one embodiment, the semiconductor layer consists of a material which is not silicon or silicon-based. As a result thereof, there is an interface between the silicon microparticle and the semiconductor layer, which interface is formed between silicon (i. e. the material of the silicon microparticles), and a material, which is not silicon (the material which forms the semiconductor layer). Such interface is referred to as a "heterojunction", herein. The term "to be in contact with", when used in the context of the silicon microparticle being "in contact with" said semiconductor layer and said conductor layer, is meant to refer to a scenario, wherein the silicon microparticle is in physical and/or electrical contact with the semiconductor layer and the conductor layer.

In one embodiment, said photovoltaic device is a solar cell. Preferably, said photovoltaic device is a heterojunction photovoltaic device.

In one embodiment, the conductor layer comprises a metal or metal alloy the work function of which matches the Fermi energy (E_{F}) of the silicon microparticle, preferably differs by 0.5 eV or less therefrom. Its choice depends also on which type of silicon is used. The choices of the conductor (15) may depend on whether the silicon is n-type or p-type. In general, it may be advantageous for the work function (WF) of the conductor (which could comprise a single element or alloy) to match the Fermi energy (E_{F}) of the silicon layer, which depends on its doping. E_{F} is close to the conduction band energy (E_{CB}) in the case of n-type silicon, whereas it is close to the valence band energy (E_{VB}) in the case of p-type silicon. Based on these criteria, a conductor with a WF close to 4.1 eV is preferable in the case of n-type silicon; examples include magnesium (3.7 eV), hafnium (3.9 eV), manganese (4.1 eV), indium (4.1 eV), gallium (4.2-4.3 eV), bismuth (4.2-4.3 eV), silver (4.3-4.6 eV), aluminum (4.2-4.3 eV), vanadium (4.3 eV ), zinc (3.6-4.3 eV), titanium (3.8-4.3 eV), and tin (4.1-4.4 eV). Preferable metal alloys in the case of n-type silicon include brass (comprising, e.g., 70wt% Cu and 30wt% Zn) and bronze (comprising, e.g., 90wt% Cu and 10wt% Sn); the work functions of these alloys are expected to lie between the values of the pure elements. Conversely, a conductor with a WF close to 5.1 eV is preferable in the case of p-type silicon; examples include cobalt (5.0 eV), germanium (5.0 eV), carbon (5.0 eV), gold (5.0-5.4 eV), palladium (5.1-5.2 eV), and nickel (5.2 eV). [The WF values are from H. B. Michaelson (1977) Journal of Applied Physics 48, 4729-4733, the CRC Handbook of Chemistry and Physics (2000-2001) 81st edition, page 12-130, and N. D. Orf et al. (2009) Applied Physics Letters 94, 113504.]

In one embodiment, said conductor layer (15) comprises a layer (31) comprising tin or a tin-alloy, which layer (31) is in direct contact with said insulator layer (17).

The layer (31) provides a metallic contact with a low melting point (232 °C for pure tin) and low work function (4.1-4.4 eV). Tin can be plated onto other conductors such as aluminum electrolytically or electrolessly.

Tin and some of its alloys having low melting points (Tₘ) and suitable work functions (WF) are: Sn (Tₘ ∼232 °C; WF 4.1 eV), Sn₉₁Zn₉ (Tₘ ∼199 °C; WF 3.9 eV), Sn_{96.5}Ag_{3.5} (Tₘ ∼221 °C; WF 4.1 eV), Sn₉₀Au₁₀ (Tₘ ∼217 °C; WF 4.3 eV). [The values of Tₘ and WF are from N. D. Orf et al. (2009) Applied Physics Letters 94, 113504.]

In one embodiment, the semiconductor layer comprises a p-type semiconductor or an n-type semiconductor. As with the choice of conductor, the choice of the semiconductor (19) may depend on whether the silicon is n-type or p-type. In general, the semiconductor can be either p-type (when the silicon microparticles are n-type) or n-type (when the silicon microparticles are p-type). In the case of n-type silicon microparticles, it may be advantageous for E_{VB} of the p-type semiconductor to be close to E_{VB} of the silicon microparticle. In the case of p-type silicon microparticles, it may be advantageous for E_{CB} of the n-type semiconductor to be close to E_{CB} of the silicon microparticle. Based on these criteria, a p-type semiconductor with an E_{VB} close to 5.1 eV is preferable in the case of n-type silicon; examples include CuI, CuSCN, Cu₂O, and CuBr. Other p-type semiconductors that may be used include delafossites (CuMO₂, M = B, Al, Cr, Sc, Y, In, Ga), SrCu₂O₂, and layered oxychalcogenides (La_{1-X}Sr_{X}CuOS). Conversely, an n-type semiconductor with an E_{CB} close to 4.1 eV is preferable in the case of p-type silicon; examples include ZnO, TiO₂ WO₃, SrTiO₃, and SnO₂ Furthermore, the valence and conduction band energies of the specific semiconductors can be adjusted by doping or dedoping them. For example, the concentration of holes in CuI, which is intrinsically p-type, can be increased by oxidizing a fraction of either the Cu-ions (from Cu⁺ to Cu⁺²) or the I-ions (from I- to I⁰), while the concentration of holes can be decreased by reducing a fraction of the Cu-ions (from Cu⁺ to Cu⁰). The term to "match", when used in conjunction with energy levels, is meant to refer to energy level differences not being greater than 0.5 eV, preferably not greater than 0.3 eV. The term "to be close to", as used herein in the context of valence bands or conductance bands is meant to refer to energy differences not being greater than approximately 0.5 eV.

As used herein, the term "conductor" refers to an electrical conductor, which is a material that permits electrons to flow freely from atom to atom and molecule to molecule, while the term "insulator" refers to a material that is nonconductive, i.e. one that impedes the free flow of electrons. A "semiconductor" is a material that is an insulator at very low temperature, but which has a sizable electrical conductivity at room temperature, i.e. a material whose electrical conductivity at room temperature is between that of a conductor and that of an insulator. Roughly, conductors and insulators have conductivities at room temperature of ≥(10-10²) S/cm and ≤(10⁻⁹-10⁻⁷) S/cm, respectively.

As used herein, the terms "valence band energy" and "conduction band energy" refer to electronic energy levels in a semiconductor or insulator. The difference between these two energies represents the band gap energy of the material. The valence band is the highest electronic energy band that can be filled with electrons. The conduction band is the electronic energy band that is partially occupied by electrons; at sufficiently low temperatures, the conduction band is empty of electrons.

As used herein, the term "Fermi energy" or "Fermi level" refers to the electrochemical potential µ that appears in the electrons' Fermi-Dirac distribution function and is the energy of the highest occupied state at zero temperature. The Fermi energy of electrical conductors (e.g., metals or heavily doped semiconductors) corresponds to the upper limit of the valence band, while for semiconductors or insulators it is inside the band gap between the valence band and the conduction band. The "work function" is defined as the minimum work required for extracting an electron from the Fermi level of a condensed phase and placing it into the so-called vacuum level just beyond the influence of the electrostatic forces.

The term "microparticle", as used herein, refers to a micrometer-sized particle. In one embodiment, said silicon microparticle (13) has a median volume-based size of 5-500 µm, preferably 5-250 µm, more preferably 5-100 µm, most preferably 10-100 µm.

In one embodiment, the silicon microparticles are irregular in shape, non-spherical and polydisperse in size. In order to nevertheless define their size more precisely, the term "median volume-based size" is used which is meant to specify that such a size equals the size of a spherical particle (with a defined diameter) having the same volume as the irregular sized silicon microparticle.

In one embodiment, said conductor layer (15) has a thickness in the rage of from 0.1 µm to 200 µm, more preferably from 10 µm to 100 µm. In one embodiment, the layer (31) comprising tin or a tin-alloy has a thickness in the rage of from 0.1 µm to 10 µm.

In one embodiment the semiconductor layer (19) has a thickness in the rage of from 5 nm to 1 µm, preferably 20 nm to 200 nm.

In one embodiment, the insulator layer has a thickness in the range of from 1 nm to 100 µm, preferably 2 nm to 10 µm.

In one embodiment, said insulator layer (17) comprises an organic film deposited onto conductor layer (15) prior to depositing silicon microparticles (13). Layer (17) may be deposited using solution methods, such as spin-coating or dipping, or by using vapour phase methods, such as evaporation or chemical vapour deposition. Suitable materials for insulators deposited by these methods include organic polymers with non-conjugated backbones (such as polyacrylic acid, polyvinyl phosphonic acid, cellulose acetate, polyvinyl phenol, polyvinyl butyral, and paralene), inorganic oxides such as aluminium oxide, and organic-inorganic composite materials such as organosilicates. Insulator layer (17) prepared according to this embodiment has a preferred thickness in the range 0.01 µm to 10 µm. In one embodiment, said layer has self-repairing properties.

In one embodiment, said insulator layer (17) is introduced after comprises a self-assembled monolayer (SAM) formed by chemisorption of molecules having the general structure X-organic-Y, wherein X- represents (HO)₂P(=O)- (phosphonic acid group), (HO)₂P(=O)O-(phosphoric acid group), or HOC(=O)- (carboxylic acid group), -Y represents -CH₃ (methyl group), -C(=O)OH (carboxylic acid group), -OH (alcohol group), -NH₂ (amino group), -SH (thiol group), -Cl (chloro group), -Br (bromo group), -I (iodo group), -CH=CH₂ (vinyl group), -OC(=O)CH=CH₂ (acrylate group), -OC(=O)CH=CHCH₃ (methacrylate group), - OC(=O)C(CH₃)₂Br (2-bromo-2-methyl-proprionate group), or -OCH₂C=CH (propargyl ether group), and wherein -organic- represents a hydrocarbon chain or cycle or chain-cycle combination comprising at least 10 carbon atoms. Insulator layer (17) prepared according to this embodiment has a preferred thickness in the range of 1 nm to 3 nm. In another embodiment, said insulator (17) comprises a modified form of said SAM in which at least one additional molecular layer is attached via the -Y group, either by electrostatic adsorption, covalent bond formation (including polymerization), or by formation of a metal coordination complex. Insulator layer (17) prepared according to this embodiment has a preferred thickness in the range of 2 nm to 100 nm.

In one embodiment, said silicon microparticle is a planarized silicon microparticle (13'). Such planarized silicon microparticle (13') is characterized by a planar surface on one side of the microparticle. Planarization can be achieved by, for example, polishing or mechanically induced shearing.

In one embodiment, said planarized silicon microparticle (13') is co-planar with the interface between said semiconductor layer (19) and said insulator layer (17).

The term "co-planar with", as used herein, is meant to refer to a situation where the planar surface of said planarized silicon microparticle (13') lies in one plane with the interface between said semiconductor layer (19) and said insulator layer (17).

In one embodiment, said silicon microparticle (13) is partially embedded in said semiconductor layer (19). Accordingly, in one embodiment of the present invention, said photovoltaic device comprises silicon microparticles which are partially embedded in said conductor layer and partially embedded in said semiconductor layer, with said insulator layer being sandwiched between the aforementioned layers.

In one embodiment, the photovoltaic device according to the present invention further comprises an encapsulating layer (25) on said semiconductor layer (19) opposite of said insulator layer (17). In one embodiment, the encapsulating layer (25) comprises one or several materials which are transparent, flexible and provide good resistance to heat, moisture, and oxigen. The encapsulating layer may comprise a laminate of two or more layers with different compositions. The encapsulating layer may also comprise a composite of two or more materials. Preferred organic polymers for encapsulating layer (25) include ethyl vinyl acetate (EVA; ethylene-vinyl acetate copolymer), polyvinyl butyral (PVB), polyurethane, poly(n-butyl) acrylate, silicone rubber, and polyvinyl alcohol. Preferred composite materials for encapsulating layer (25) include composites of said organic polymers and layered inorganic silicate or aluminosilicate materials including clays such as montmorillonite or kaolinite.

In one embodiment, the encapsulating layer has a thickness in the rage of from 1 µm to 1000 µm, preferably from 10 µm to 100 µm. In one embodiment, the photovoltaic device according to the present invention further comprises an adhesive layer (29) on said conductor layer (15) opposite of the insulator layer (17). In one embodiment, the adhesive layer (29) comprises or is made of or consists of an adhesive, for example a pressure sensitive adhesive or a composite of an adhesive and an electrically conductive material, such as for example a pressure sensitive adhesive (PSA) which may be based on natural rubber, acrylic ester, silicone rubber, butyl rubber, EVA (ethylene-vinyl-acetate), styrene block-copolymers, etc., or a composite of a PSA and electrically conductive material, e. g. aluminium flakes, silver flakes, silver nanowire, silver coated aluminium particles, silver coated copper particles, graphite particles, nickel coated graphite particles, carbon nanotubes, graphene sheets, etc. In one embodiment, the adhesive layer has a thickness in the range of from 10 µm to 100 µm.

In one embodiment, the silicon microparticle further comprises a porous silicon layer (37). Such porous silicon layer, in one embodiment, has a thickness in the range of from 0.1 µm to 1 µm.

In one embodiment, the photovoltaic device according to the present invention further comprises a barrier layer (33) between the silicon microparticle (13) and the conductor layer (15). Barrier layers (33) and (35) may differ from insulator layer (17) with respect to composition and/or thickness. They may also differ in function, serving more as a tunnel barrier than a charge blocking layer.

Preferably, said barrier layer (33) is formed of a material independently selected from the group comprising silicon oxide (SiO_{z}, where 1 ≤ z ≤ 2), aluminium oxide (Al₂O_{z}, where 2 ≤ z ≤ 3), aluminium-silicon mixed oxide with composition Al₂ₓSi_{y}O_{z}, where (2x + y) ≤ z ≤ (3x + 2y). In another preferred embodiment, said barrier layer (35) is formed of silicon oxide (SiO_{z}, where 1 ≤ z ≤ 2), a combination of said silicon oxide and a monolayer or multilayer thereon formed by chemisorption of organofunctional alkoxysilane or chlorosilane molecules to form covalent -Si-O-Si- bonds. In another preferred embodiment, said barrier layer (35) comprises a monolayer formed by chemisorption of organofunctional molecule to form covalent -Si-C-bonds between carbon atoms of said molecules and silicon atoms of the silicon microparticle. In said embodiments, said barrier layer (33) or (35) has a thickness in the range of 1 nm to 20 nm, preferably in the range of 1 nm to 3 nm.

In one embodiment, said insulator layer (17) or said semiconductor layer (19) comprises a luminescent dopant (39, 43).

In one embodiment, said encapsulating layer (25) comprises a luminescent dopant (41).

The function of the dopant is to convert light that is not absorbed by the silicon into light that is absorbed by the silicon. This process involves either "down-conversion", in which ultraviolet-violet-blue photons are absorbed by the dopant and re-emitted as green-orange-red-far red photons, or "up-conversion", in which infrared photons are absorbed by the dopant and re-emitted as green-orange-red-far red photons.

The efficiency of said photovoltaic device may be increased by incorporating luminescent dopants ("phosphors") into one or more of the transparent layers, i.e., insulator layer (17), semiconductor layer (19), or encapsulating layer (25). Luminescent dopants essentially modify the solar spectrum available for absorption by silicon microparticles either by converting higher energy photons into lower energy ones (either down-conversion or photoluminescence) or by converting lower energy photons into higher energy photons (up-conversion). Preferably, luminescent dopants for down-conversion or photoluminescence are located in either encapsulating layer (25) or semiconductor layer (19), and dopants for up-conversion are located in insulator layer (17). Luminescent dopants for down-conversion and photoluminescence preferably absorb sunlight in the wavelength range of 350 nm to 550 nm and emit light in the range of 450 nm to 1100 nm. Dopants for up-conversion preferably absorb sunlight with wavelengths >950 nm and emit light in the range of 500 nm to 900 nm. Said dopants may comprise ions and/or molecules, either singular, or as clusters or complexes, polymers, or nanoparticles. Preferred luminescent dopants contain one or more ions of rare earth (RE) elements, also known as lanthanides, or a combination of RE ion and transition metal ion. Preferred dopants for down-conversion located in semiconductor layer (19) are trivalent ytterbium ions (Yb³⁺) or coordination complexes thereof, e.g., YbLₓ orYb(L¹)_{y}(L²)_{z}, where L, L¹, and L² represent the coordinated forms of uni- or multidentate organic ligands such as β-diketone, hydroxyquinoline, phenanthroline, salicylidene, aromatic carboxylic acid, dithiocarbamate, aminopyrazine, tetrathiafulvalene, hydroxyflavone, or derivatives thereof, and x, y, and z have values between 1 and 5, and where L, L¹, and/or L² has a lowest triplet state energy level in the range of 2.2 eV to 2.7 eV, and wherein Yb³⁺ has a coordination number (CN) in the range 6 ≤ CN ≤ 12, most preferably CN = 8. Other preferred dopants for down-conversion located in semiconductor layer (19) are copper(I) halide with arylphosphine ligands, such as (MePh₂P)₃CUI, where MePh₂P represents the dimethylphenylphosphine ligand, and copper(I) halide complexes with both arylphosphine and N-heteroaromatic ligands, such as {Cu₂(u-I)₂(PPh₃)₂}µ-bpy, where PPh₃ represents the triphenylphosphine ligand and bpy represents the 4,4'-bipyridine ligand.

In one embodiment, said photovoltaic device further comprises an electric circuit with a first contact (23) to said semiconductor layer (19) and a second contact (21) to said conductor layer (15) and with electrodes being connected to an external load (27).

The objects of the present invention are also solved by a method of producing a photovoltaic device as defined above, said method comprising the step of:
- partially embedding silicon microparticles in a conductor layer.

Preferred embodiments of the method of producing a photovoltaic device are as follows:
**Method 1**, whereby insulator layer (17) is deposited onto conductor layer (15) *before* silicon microparticles (13) are deposited:
   - pulverizing doped crystalline silicon to provide doped silicon microparticles (13)
   - depositing insulator layer (17) onto conductor layer (15)
   - depositing doped silicon microparticles (13) onto insulator layer (17)
   - pressing doped silicon microparticles (13) through insulator layer (17) and partially into conductor layer (15)
   - depositing semiconductor layer (19)
   - providing electrical contact (21) to conductor layer (15)
   - providing electrical contact (23) to semiconductor layer (19), and
   - depositing encapsulating layer (25).
**Method 2**, whereby insulator layer (17) is deposited onto conductor layer (15) *after* silicon microparticles (13) are deposited:
   - pulverizing doped crystalline silicon to provide doped silicon microparticles (13)
   - depositing doped silicon microparticles (13) onto conductor layer (15)
   - pressing doped silicon microparticles (13) partially into conductor layer (15)
   - depositing insulator layer (17) selectively onto conductor layer (15) not occupied by partially embedded doped silicon microparticles (13)
   - depositing semiconductor layer (19)
   - providing electrical contact (21) to conductor layer (15)
   - providing electrical contact (23) to semiconductor layer (19), and
   - depositing encapsulating layer (25).
**Method 3**, whereby conductor layer (15) is deposited onto silicon microparticles (13) partially embedded in temporary layer (47)]
   - pulverizing doped crystalline silicon to provide doped silicon microparticles (13)
   - depositing doped silicon microparticles (13) onto temporary layer (47)
   - pressing doped silicon microparticles (13) partially into temporary layer (47)
   - depositing conductor layer (15) onto silicon microparticles (13) partially embedded in temporary layer (47)
   - removing temporary layer (47)
   - depositing insulator layer (17) selectively onto conductor layer (15) not occupied by partially embedded doped silicon microparticles (13)
   - depositing semiconductor layer (19)
   - providing electrical contact (21) to conductor layer (15)
   - providing electrical contact (23) to semiconductor layer (19), and
   - depositing encapsulating layer (25).

In a preferred embodiment, said silicon microparticles are embedded into said conductor layer, e.g. aluminum foil, by cold pressing. In another preferred embodiment, said semiconductor layer, e.g. cuprous iodide layer, is deposited by spin-coating of a precursor solution followed by baking at 80 °C for approximately 30 minutes.

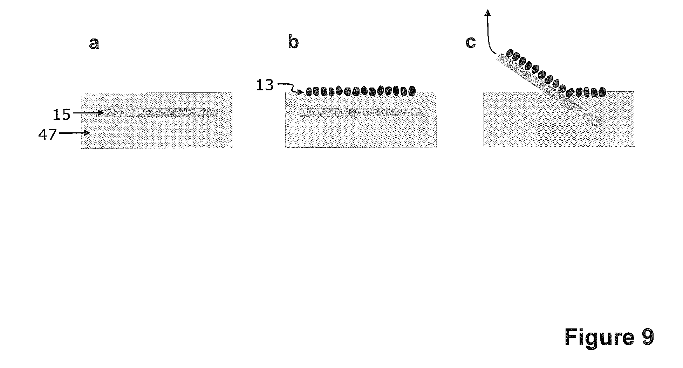

In the following, embodiments of methods for depositing and preparing layers in accordance with the present invention are described as follows:
In one embodiment, silicon microparticles (13) are deposited onto a substrate such as conductor layer (15) using a dry powder coating process, preferably an electrostatic spray deposition technique. In this method, the particles are electrostatically charged and sprayed onto an electrically grounded substrate. U.S. Pat. No. 5,075,257 discloses such a method and apparatus, wherein silicon powder of optimum particle size is aerosolized, charged, and then electrostatically deposited onto high melting point substrates, which may include semiconducting, insulating, and conducting materials such as silicon, sapphire, and molybdenum, respectively. Another preferred embodiment is illustrated in **Figure 9**, where in step **a** a substrate, in this case conductor layer (15), is immersed in a liquid bath (47), preferably a polar liquid such as water, in step **b** silicon microparticles (13) are spread on the surface of the liquid providing a densely packed particle layer, and in step c the substrate is pulled through said particle layer whereby the layer is transferred to (15), thereby providing a densely packed layer of silicon microparticles (13) on surface of conductor layer (15). In one embodiment, said conductor layer (15) is a metal foil supported on a flexible organic foil. In another embodiment, said substrate onto which silicon microparticles are deposited is temporary embedding layer (49).

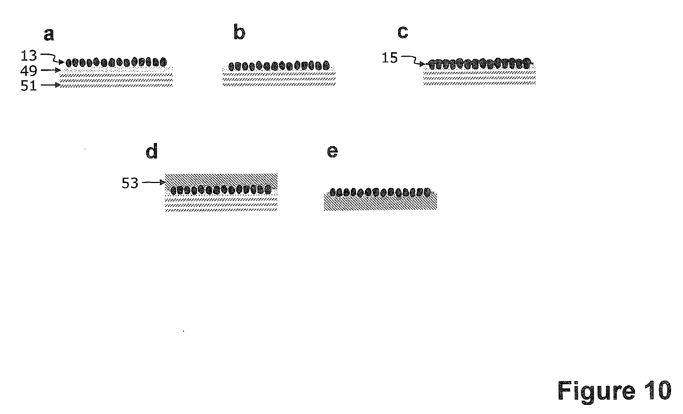

**Method 3** for producing a photovoltaic device, as outlined above, is illustrated in **Figure 10****,** wherein **a** silicon microparticles (13) are deposited onto a temporary layer comprising a soft material (49) that is supported by a harder one (51), such as glass. Preferably, support layer (51) is flexible, such as a polymeric film (e.g., polyethylene terephthalate (PET) or polycarbonate (PC)) or thin (≤ 100 µm) glass foil. Preferably, the thickness of temporary layer (49) is less than the median size of microparticles (13), more preferably the thickness is at least half the median size. Suitable materials for layer (49) include waxes, such as paraffin wax and polyethylene glycol (also known as Carbowax or polyethylene oxide). After step a, in step **b** the silicon microparticles (13) are pressed into layer (49) so that they are partially embedded. Subsequently, in step c silicon microparticles (13) are coated with a continuous layer of conductor (15) on surfaces not embedded in layer (49). Suitable methods for depositing conductor layer (15) include evaporation and sputtering. A preferred conductor for layer (15) is aluminium. In one embodiment, said conductor layer (15) has a thickness in the range of 10 nm to 1 µm, preferably in the range of 50 nm to 500 nm. To provide support for this layer and silicon microparticles it coats, in step **d** a thicker layer (53) is subsequently deposited. In one embodiment, support layer (53) comprises a flexible crosslinked organic polymer such as polyvinyl butyral (PVB), polydimethylsiloxane (PDMS), polyurethane, or cellulose acetate. In another embodiment, support layer has a thickness in the range of 10 µm to 1 mm. Finally, in step e temporary layer (49) and its support (51) are removed to provide a layer of silicon microparticles (13) partially embedded in a conductor layer (15) on a support (53). In one embodiment, said temporary layer (49) and its support (51) are removed by dipping the assembly obtained from step e in a solvent bath that selectively dissolves temporary layer (49).

Semiconductor layer (19) may be deposited by one of many thin film deposition techniques, which can be generally divided into vapour phase and solution phase techniques. Vapour phase deposition methods include sublimation, vacuum evaporation, molecular beam epitaxy (MBE), chemical vapour deposition (CVD), sputter deposition (RF, magnetron, and ion beam), and pulsed laser deposition. Solution phase deposition methods include spin-coating, dip-coating, spray deposition, sol-gel, and chemical solution deposition. In a one embodiment, semiconductor layer (19) comprises a metal halide or metal pseudohalide (e.g., thiocyanate, isothiocyanate, cyanate, isocyanate, or cyanide) deposited by a solution phase technique. In another embodiment, semiconductor layer (19) comprises a blend of semiconductor and organic polymer. In a preferred embodiment, said metal is copper, silver, or gold. In a preferred embodiment, semiconductor layer (19) is deposited by spin-coating, dip-coating, or spraying a solution of metal halide or metal pseudohalide dissolved in pyridine or a liquid pyridine derivative, followed by thermal treatment to remove said pyridine or pyridine derivative from the film. In a preferred embodiment, said solution of metal halide or metal pseudohalide contains an organic polymer. In a preferred embodiment, semiconductor layer (19) comprises a blend of cuprous iodide and organic polymer. In a preferred embodiment, said organic polymer is a thermoplastic resin such as a vinyl polymer (e.g., polyvinyl acetate, polyvinyl alcohol, or polyvinyl butyral), a vinylidene polymer (e.g., polyvinylidene chloride or polyvinylidene fluoride), an acrylic polymer (e.g., polymethacrylate or polymethylmethacrylate), or copolymers thereof. In another preferred embodiment, the ratio of the mass of organic polymer to the mass of semiconductor in the solution used to prepare semiconductor layer (19) is in the range of 0.003 to 0.3, preferably in the range of 0.02 to 0.2.

In one embodiment, silicon microparticles (13) partially embedded in conductor layer (15) and partially embedded in insulator layer (17) are treated to generate a porous silicon layer (37) covering the surface of said microparticles (13) before depositing semiconductor layer (19). In this process, the silicon microparticle surface is treated with an acidic aqueous solution containing a fluoride ion (F⁻) salt under oxidizing conditions, said oxidizing conditions being induced by either (i) electrochemical, (ii) photoelectrochemical, or (iii) chemical ("stain-etching") means. In this embodiment, said insulator layer (17) protects the conductor layer (15) from reaction with said acidic fluoride salt solution. In a preferred embodiment, porous layer (37) is formed by stain-etching with an acidic aqueous solution wherein the fluoride ion salt is ammonium bifluoride (NH₄HF₂) and the oxidant is nitric acid (HNO₃), and wherein the concentration of ammonium bifluoride is in the range of 0.001 M and 0.01 M and the concentration of nitric acid is in the range of 10 M and 20 M. In another preferred embodiment, said stain-etching process is conducted for a period of time in the range of 3 s to 300 s, preferably in the range of 10 s to 100 s.

The main advantageous features of this invention compared to other photovoltaic solar cells are the following:
1) It utilizes by-products of the electronics industry, i.e. silicon shards, powder, etc. of high purity crystalline silicon. Although these by-products are often recycled, their direct use as raw materials should significantly reduce production costs for solar cells according to the present invention. Additionally, the amount of silicon required is significantly less than is required for wafer-based silicon solar cells.
2) Silicon-based solar cells are intrinsically more stable than organic-based ones.
3) It is an all solid-state device, allowing simple encapsulation techniques to be used.
4) Non-planar geometries are possible, so that geometries optimized for photon collection can be used.
5) The solar cells can made on plastic substrates since the fabrication steps do not require high temperatures. This feature means that the cells can be flexible and should allow low cost, roll-to-roll processing to be used.

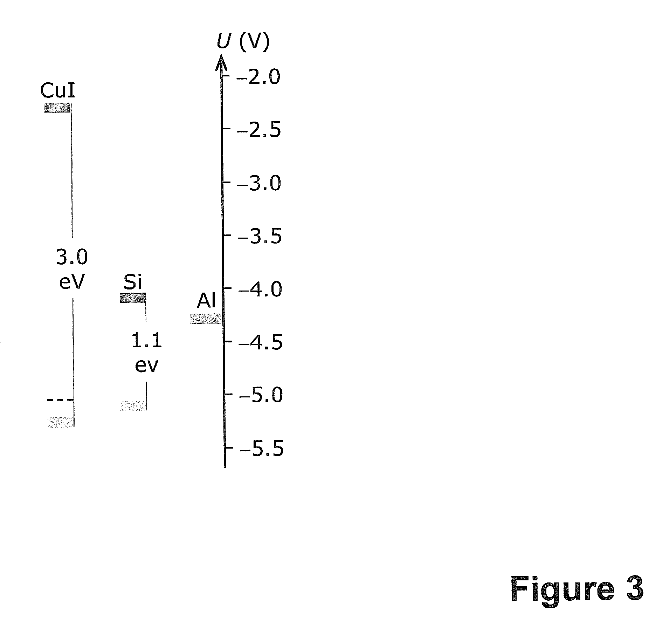

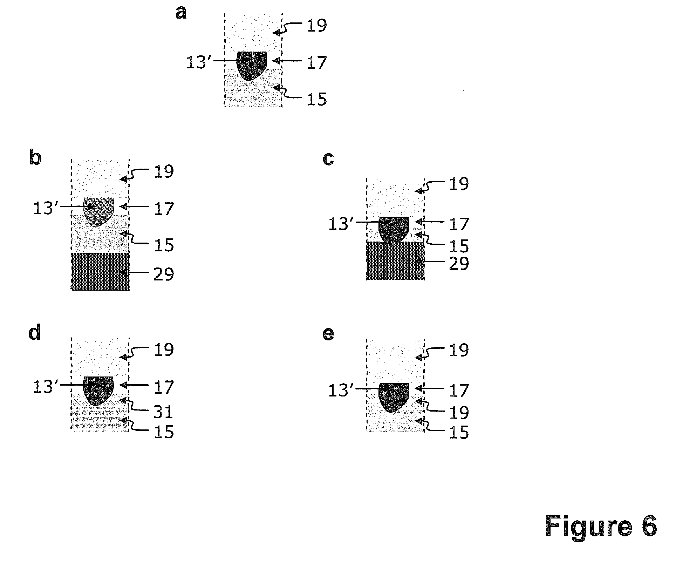

The present invention is now further described by means of the following figures:

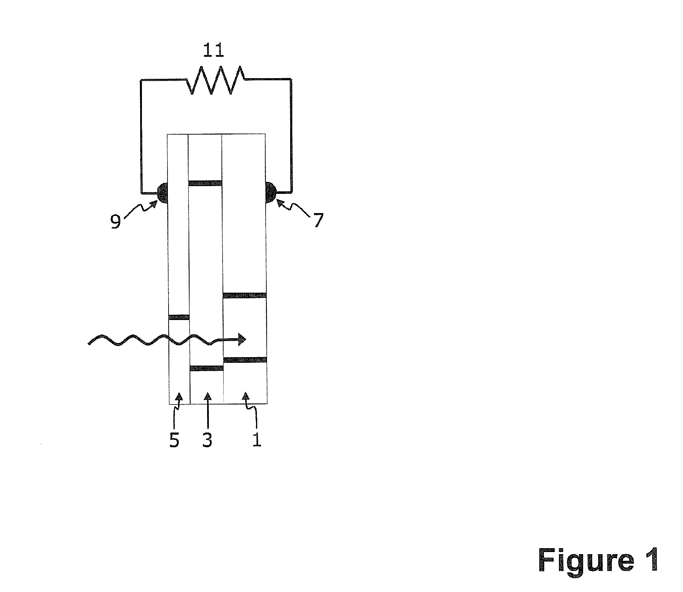

**Figure 1** is a diagram illustrating an example of a p-n heterojunction photovoltaic device from the prior art [H. Iimori et al. (2008) J. Phys. Chem. C, 112, 11586-11590] having the structure "ITO/p-CuI/n-Si" prepared by the deposition of a p-CuI layer (3) on a single crystal n-Si(H) (or n-Si(CH₃)) wafer (1). The indium tin oxide (ITO) layer (5), a contact to the Si layer (7), a contact to the ITO layer (9) and load (11) are also depicted. The high open-circuit photovoltage (V_{oc}) reaching 0.617 V in the device is attributed to the formation of an ideal minority-carrier controlled p-CuI/n-Si junction. The broad horizontal lines in the diagram represent the relative positions of the work function of ITO and the valence and conduction bands of CuI and Si.

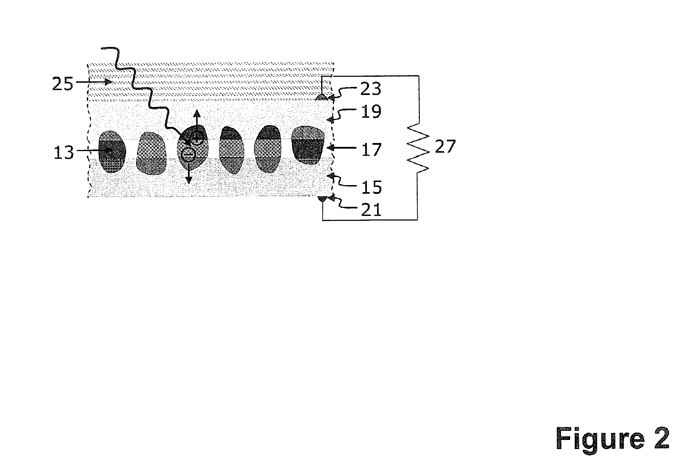

**Figure 2** illustrates the general concept of the present invention and components of the device. Absorption of a photon of light by a silicon microparticle generates an electron-hole pair, which dissociates, with one of the charge (e.g., the electron) diffusing to the conductor layer (15) and the other charge (e.g., the hole) diffusing to the semiconductor layer (19). These charges are collected and recombined through an external load (27), providing an electric current. Silicon oxide particles (13), an insulator layer (17), a bottom contact to the conductor layer (21), a top contact to the semiconductor layer (23), and an encapsulating layer (25) are also depicted. Particularly preferred embodiments include silicon particles (13) that are n-type with a size of 10-100 µm, a conductor (foil) layer (15) comprising aluminium, a semiconductor layer (19) comprising p-type cuprous iodide, and an encapsulating layer (25).
In a preferred embodiment, said top contact (23) comprises a thin (about 10 nm or less) conductor film, where said conductor is preferably Cu, Ag, or Au. In another preferred embodiment, said top contact (23) comprises a conductor grid. In another preferred embodiment, said encapsulating layer (25) includes an antireflection coating
**Figure 3** shows the approximate energy levels of the valence and conduction bands of CuI and Si and the work function of Al relative to the vacuum level in a photovoltaic device according to the present invention.

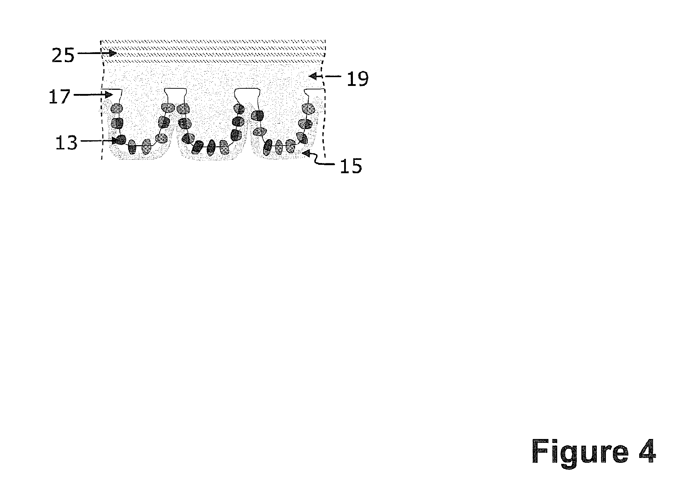

**Figure 4** illustrates an example of a non-planar configuration of the photovoltaic device according to the present invention. Non-planar configurations may be more effective for light collection.

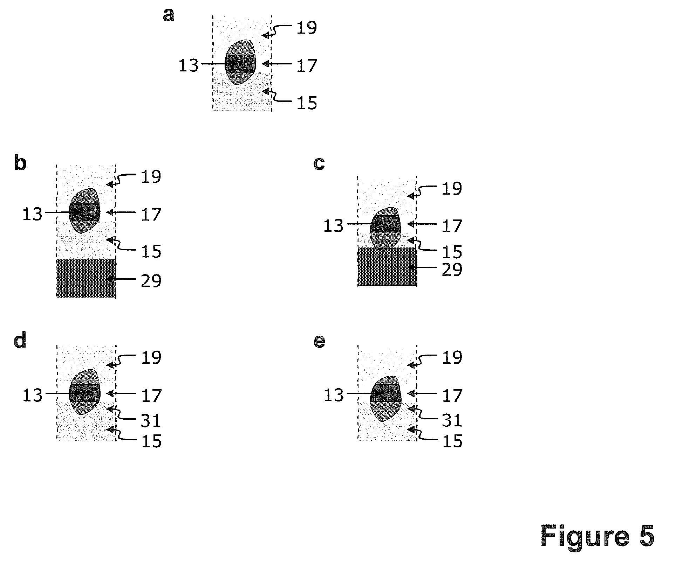

**Figure 5a** is a diagram representing a "unit cell" of a photovoltaic device according to the present invention, comprising a silicon microparticle (13) partially embedded in a conductor layer (15) and partially embedded in a semiconductor layer (19), with an insulator layer (17) sandwiched between layers (15) and (19). For simplicity, the contacts, encapsulating layer, and external load are omitted from these "unit cell" diagrams. Four possible additional embodiments are illustrated in **Figure 5**. In diagram **b**, an adhesive layer (29) is attached to the bottom of the conductor layer. This layer can provide extra mechanical stability to the cell during its manufacture and use. Another function of the adhesive layer arises, if the silicon particles pierce through the conductor layer, as indicated in diagram **c**. In that case, the adhesive layer can help to prevent the particles from moving and loosing electrical contact with the conductor layer. Furthermore, if the adhesive layer is itself electrically conductive, it can serve as a conductive matrix for particles that may have poor contact with the conductor layer. In this embodiment, the conductive filler of the adhesive should preferably have a relatively low work function, i.e., silver or aluminium would be preferable to carbon or nickel as the filler. Diagrams **d** and e illustrate the use of a layer (31) comprising tin (or a tin alloy) being in direct contact with insulator layer (17); in **d** the silicon microparticle (13) contacts just the tin layer, while in **e** it penetrates the tin layer and also contacts the actual conductor layer (15).
The embodiments illustrated in **Figure 6** are analogous to those in **Figure 5** except that the surface of the silicon microparticle is planarized (13') and is co-planar with the interface between the conductor layer (15) and insulator layer (17).

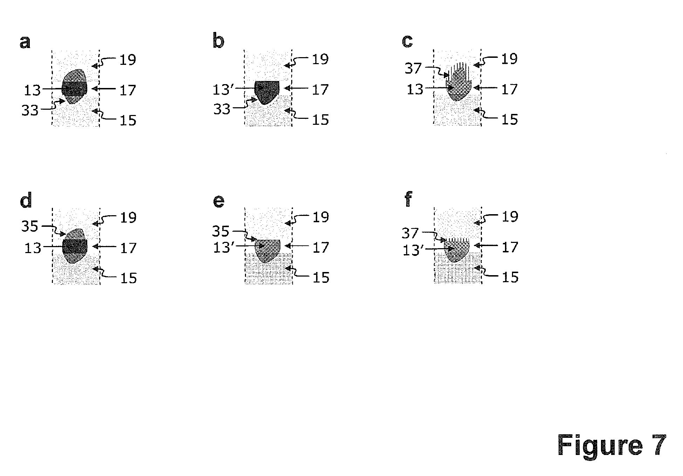

Figure 7a represents an additional embodiment in which a barrier layer (33) is sandwiched between the silicon microparticle (13) and the conductor layer (15), while in diagram b a barrier layer (35) is sandwiched between the silicon microparticle (13) and the semiconductor layer. Diagrams **c** and **d** are analogous to **a** and **b** except that silicon microparticle is a planarized silicon microparticle (13'). Diagram **e** in **Figure 7** illustrates an additional embodiment in which the surface of the silicon microparticle (13) that is in contact with the semiconductor layer (19) is coated with a layer of porous silicon (37); diagram **f** illustrates the analogous case with a planarized silicon microparticle (13').

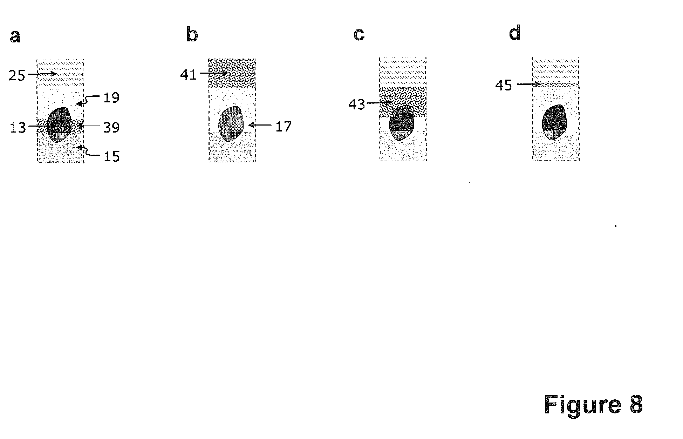

**Figure 8** illustrates four additional embodiments. Diagram **a** depicts the embodiment whereby a luminescent dopant is incorporated into insulator layer (17) to form layer (39). In diagram b, a luminescent dopant is incorporated into encapsulating layer (25) to form layer (41), while in diagram c a luminescent dopant is incorporated into semiconductor layer (19) to form layer (43). Diagram d depicts the embodiment whereby layer (45) comprising a hole-transporting, electron-blocking (HTEB) substance or an electron-transporting, hole-blocking (ETHB) substance is included between semiconductor layer (19) and electrical contact (23).
The purpose of layer (45) in **d** is to selectively transport the majority charge carriers from the semiconductor to the electrode, i.e., the layer is HTEB-type when (19) is a p-type semiconductor and it is ETHB-type when (19) is n-type. Examples of substances for HTEB layers include PEDOT:PSS (poly(ethylenedioxythiophene):poly(styrene sulfonate)), triarylamine compounds, carbazole compounds, and oxidized graphite particles. Examples of substances for ETHB layers include organic phosphine oxide compounds, thiophene-S,S-dioxide compounds, and carborane compounds. When semiconductor (19) is p-type, layer (45) is preferably a film of graphene oxide with a thickness in the range of 1 nm to 4 nm. In one embodiment, said film of graphene oxide is a composite with an organic polymer such as polyvinyl alcohol.
**Figure 9** illustrates a method for depositing a dense layer of silicon microparticles (13) onto a substrate comprising conductor layer (15). In step **a**, said substrate is immersed in a bath of liquid (47); in step **b**, silicon microparticles (13) are spread on the surface of said liquid forming a densely packed film; in step c, said film is transferred to a surface of said substrate by drawing the latter through the surface of said liquid at an angle between 0° and 90°.
The embodiment depicted in **Figure 9** is based on observations of the inventors that hydrophobic silicon microparticles tend to collect into a dense film at the surface of a hydrophilic liquid such as water. The substrate onto which the film is transferred may be composed of substances other than conductor, including a wax such as paraffin wax or polyethylene glycol.
**Figure 10** illustrates **Method 3** for producing a photovoltaic device. In step **a**, silicon microparticles (13) are deposited onto a temporary layer comprising a soft material (49) that is supported by a harder one (51), such as glass. In step **b**, said microparticles are pressed into layer (49) (i.e. temporary embedding layer for the silicon microparticles) so that they become partially embedded in said layer. In step **c**, the microparticles are coated with a continuous layer of conductor (15) on exposed surfaces of the microparticles, i.e. on surfaces not embedded in layer (49). In step **d**, a support layer (53) is deposited on conductor layer (15). Finally, in step e, temporary layer (49) and its support (53) are removed to provide a layer of silicon microparticles (13) partially embedded in a conductor layer (15) on a support (53).

## Claims

1. A photovoltaic device comprising
- a conductor layer (15);
- a semiconductor layer (19);
- an insulator layer (17) sandwiched between said conductor layer (15) and said semiconductor layer (19); and
- a silicon microparticle (13),
wherein said silicon microparticle (13) is partially embedded in said conductor layer (15) and partially embedded in said insulator layer (17),
wherein said silicon microparticle (13) is in contact with said semiconductor layer (19) and said conductor layer (15), and
wherein said semiconductor layer (19) comprises a material which is not silicon.

2. The photovoltaic device according to claim 1, wherein there is an interface between said silicon microparticle (13) and said semiconductor layer (19) which interface is a heterojunction.

3. The photovoltaic device according to any of claims 1 and 2, wherein said conductor layer (15) comprises a metal or metal alloy or a carbon-based material which is selected from the group comprising magnesium, hafnium, manganese, indium, gallium, bismuth, silver, aluminium, vanadium, zinc, titanium, tin, brass, bronze, germanium, gold, palladium, nickel, amorphous carbon, glassy carbon, graphite, graphene, conjugated organic polymer, wherein, preferably, the metal, metal alloy or carbon-based material has a work function (WF) which differs by 0.5 eV or less from the Fermi energy (E_{F}) of the silicon microparticle (13).

4. The photovoltaic device according to any of the foregoing claims, wherein said semiconductor layer (19) comprises a p-type semiconductor or an n-type semiconductor, and/or wherein said silicon microparticle (13) comprises n-type silicon or p-type silicon.

5. The photovoltaic device according to claim 4, wherein said semiconductor layer (19) comprises a p-type semiconductor and said silicon microparticle (13) comprises n-type silicon, wherein, preferably, the valence band energy of the p-type semiconductor and the valence band energy of the n-type silicon microparticle preferably differ by 0.5 eV or less.

6. The photovoltaic device according to claim 4, wherein said semiconductor layer (19) comprises an n-type semiconductor and said silicon microparticle (13) comprises p-type silicon, wherein, preferably, the conduction band energy of the n-type semiconductor and the conduction band energy of the p-type silicon microparticle preferably differ by 0.5 eV or less.

7. The photovoltaic device according to any of the foregoing claims, wherein said silicon microparticle (13) has a median volume-based size of 5-500 µm, preferably 5-250 µm , more preferably 5-100 µm, most preferably 10-100 µm.

8. The photovoltaic device according to any of the foregoing claims, further comprising an encapsulating layer (25) on said semiconductor layer (19) opposite of said insulator layer (17), and/or further comprising an adhesive layer (29) on said conductor layer (15) opposite of said insulator layer (17).

9. The photovoltaic device according to any of the foregoing claims, wherein said silicon microparticle (13) is a planarized silicon microparticle (13'), wherein, preferably, said planarized silicon microparticle (13') is co-planar with the interface between said semiconductor layer (19) and said insulator layer (17).

10. The photovoltaic device according to any of the foregoing claims, wherein said silicon microparticle (13) further comprises a porous silicon layer (37), wherein said porous silicon layer (37) covers the surface of said silicon microparticle (13) being in contact with said semiconductor layer (19).

11. The photovoltaic device according to any of claims 1 to 9, wherein said silicon microparticle (13) is partially embedded in said semiconductor layer (19).

12. The photovoltaic device according to any of claims 1 to 9 and 11, further comprising a barrier layer (35) between said silicon microparticle (13) and said semiconductor layer (19).

13. The photovoltaic device according to any of the foregoing claims, further comprising a barrier layer (33) between said silicon microparticle (13) and said conductor layer (15).

14. The photovoltaic device according to any of the foregoing claims, wherein said insulator layer (17) or said semiconductor layer (19) comprises a luminescent dopant (39, 43), and/or wherein said encapsulating layer (25), if present, comprises a luminescent dopant (41).

15. A method of producing a photovoltaic device according to any of the foregoing claims, said method comprising the step of:
- partially embedding silicon microparticles in a conductor layer, wherein, preferably, the method comprises one of the following sequences of steps:
either a):
- providing a conductor layer (15),
- depositing an insulator layer (17) on said conductor layer (15),
- providing silicon microparticles (13),
- pressing said silicon microparticles through said insulator layer (17) and partially into said conductor layer (15),
- depositing a semiconductor layer (19) onto said insulator layer (17);
or b):
- providing, in any order, a conductor layer (15) and silicon microparticles (13),
- depositing said silicon microparticles (13) on said conductor layer (15),
- pressing said silicon microparticles (13) partially into said conductor layer (15),
- depositing an insulator layer (17) onto said conductor layer (15) such that said insulator layer (17) covers said conductor layer (15) and such that said silicon microparticles (13) pressed and partially embedded in said conductor layer (15) become also partially embedded in said insulator layer (17),
- depositing a semiconductor layer on said insulator layer;
or c):
- providing, in any order, silicon microparticles (13) and a temporary layer (49),
- depositing said silicon microparticles (13) onto said temporary layer (49),
- pressing said silicon microparticles (13) partially into said temporary layer (49), such that said silicon microparticles become partially embedded into said temporary layer,
- depositing a conductor layer (15) onto said silicon microparticles (13), partially embedded in said temporary layer (49),
- removing said temporary layer (49),
- depositing an insulator layer (17) onto said conductor layer (15) such that said insulator layer (17) covers said conductor layer (15) and such that said silicon microparticles partially embedded in said conductor layer become also partially embedded in said insulator layer (17),
- depositing a semiconductor layer (19) on said insulator layer;
and, wherein said method optionally further comprises the sequence of steps:
- providing, in any order, an electrical contact to said conductor layer (15) and said semiconductor layer (19) and depositing an encapsulating layer (25) on said semiconductor layer (19),
wherein said conductor layer, insulator layer, silicon microparticles, and semiconductor layer are as defined in any of claims 1-14.
